# EUROPÄISCHE PATENTSCHRIFT

(11) **EP 0 904 676 B1**
(45) Veröffentlichungstag und Bekanntmachung des Hinweises auf die Patenterteilung: **10.11.1999**
(21) Anmeldenummer: 97930317.9
(22) Anmeldetag: 13.06.1997
(51) Int. Cl.: H05K 7/20

(54) **GERÄTESCHRANK FÜR ELEKTRISCHE UND ELEKTRONISCHE SYSTEME**
CABINET FOR ELECTRIC AND ELECTRONIC SYSTEMS
ARMOIRE POUR SYSTEMES ELECTRIQUES ET ELECTRONIQUES

(30) Priorität: 14.06.1996 DE 19623677
(43) Veröffentlichungstag der Anmeldung: 31.03.1999
(73) Patentinhaber: Knürr-Mechanik für die Elektronik AG, D-81829 Munchen (DE)
(72) Erfinder: BOEHMER, Peter, D-01257 Dresden (DE); BRETSCHNEIDER, Rainer, D-01662 Mei en (DE); HOENISCH, Herbert, D-01623 Leuben (DE)
(74) Vertreter: Heim, Hans-Karl, Dipl.-Ing.
(86) Internationale Anmeldenummer: DE9701206
(87) Internationale Veröffentlichungsnummer: WO9748261

(56) Entgegenhaltungen:
- EP-A- 0 225 954
- DD-A- 212 871
- DE-B- 1 135 065
- DE-U- 9 408 362
- DE-U- 29 519 260
- US-A- 5 263 537
- PATENT ABSTRACTS OF JAPAN vol. 013, no. 378 (E-809), 22.August 1989 & JP 01 129497 A (FUJITSU LTD), 22.Mai 1989,
- PATENT ABSTRACTS OF JAPAN vol. 096, no. 009, 30.September 1996 & JP 08 116190 A (TOTSU SOKEN:KK;NIPPON TELEGR & TELEPH CORP <NTT>; SHIYOUDENS), 7.Mai 1996,

## Beschreibung

Die Erfindung betrifft einen Geräteschrank, insbesondere Schalt- und Steuerschrank, für elektrische und elektronische Systeme mit einem staub- und wasserdicht geschlossenen Funktionsraum, mit wenigstens einer staub- und wasserdicht schließenden Tür. Der Geräteschrank ist in gleicher Bauform und Ausrüstung für den Außeneinsatz in sehr unterschiedlichen, z.B. gemäßigten, nördlichen, subtropischen und tropischen Klimazonen geeignet.

Geräteschränke sind beispielsweise aus der Veröffentlichung Klingberg, Gottfried : "Schaltschrank und Gehäuse-Klimatisierung", Mähling Werbung, Düsseldorf bekannt.

Je nach Funktionsraumklimaanforderungen mit dem Ziel der Sicherstellung eines dauerhaft störungsarmen Betriebes der elektrischen und elektronischen Systeme bei variablen Außenklimabedingungen werden Geräteschränke dort so ausgeführt, daß durch Wärmeabfuhr über die Schrankoberfläche und/oder durch Wärmeübertrager das Überschreiten einer höchstzulässigen Funktionsraumtemperatur verhindert wird und durch Heizgeräte die Unterschreitung einer Mindestfunktionsraumtemperatur vermieden wird.

Aus der DE 295 19 260 U1 ist ein witterungsgeschützter Elektronik-Schaltschrank für die Aufstellung im Freien bekannt, der wenigstens teilweise von einer abnehmbaren, im Abstand zu den Außenflächen des Elektronik-Schaltschranks gehaltenen Schutzhaube umhüllt ist. Der so gebildete Zwischenraum steht mit der Außenluft in Verbindung. Bei starker Sonneneinstrahlung soll durch die Schutzhaube die Aufheizung und bei niederen Temperaturen die Abkühlung des Schranks reduziert werden.

Aus der DE-AS 11 35 065 ist es bekannt, mittels von Luftöffnungen in der Gerätewand, deren Querschnitt veränderbar ist, die Luftzuführung in das Innere des Gerätes einzustellen.

In der DD 212 871 wird von einer als bekannt geltenden Anordnung zur Wärmeabführung aus geschlossenen Gehäusen ausgegangen, in denen Verlustwärme erzeugende Geräte in mehreren Ebenen angeordnet sind, die einen als Tür, Wand oder Teil einer Tür oder Wand ausgeführten Wärmetauscher, der in einem inneren Kreislauf von der erwärmten Innenluft und in einem äußeren Kreislauf von der kühlen Außenluft durchströmt wird, sowie wenigstens zwei Lüfter enthält, wobei im inneren Kreislauf durch eine Abdeckung ein Kanal gebildet wird. Um eine gezielte Wärmeabfuhr von Baugruppen zu gewährleisten, wird der Innenraum durch horizontale Trennwände in voneinander getrennte Kreisläufe unterteilt, die mit dem Wärmetauscher in Verbindung stehen und mit separaten Lüftern versehen sind.

Bereits bei relativ niedrigen inneren Wärmelasten ist bei den bekannten Schränken trotz einer noch deutlich positiven Differenz zwischen höchstzulässiger Funktionsraumtemperatur und höchster Außenlufttemperatur die Lastabführung (Schrankentwärmung) nur durch zusätzliche technische Geräte, wie z.B. Luft-Luft-Wärmeübertrager, Luft-Wasser-Kühler, Kältemaschinen u.ä. möglich. Die Störanfälligkeit sowie der Wartungs- und Betriebsaufwand solcher Geräte sind vergleichsweise hoch.

Nachteilig ist weiterhin die Belegung von Funktionsraum durch die genannten Kühlgeräte und die Notwendigkeit der konstruktiven Anpassung des Funktionsraumes an die Erfordernisse der Kühlgeräte.

Aufgabe der Erfindung ist es, weitgehend wartungsfreie Elemente mit den für die anderen Geräteschrankfunktionen ohnehin nötigen Bauelemente so anzuordnen, daß insbesondere der Betriebsbereich "passive Kühlung" gegenüber bekannten Geräteschrankkonstruktionen deutlich erweitert sowie der Wartungs- und Betriebsaufwand gesenkt werden, wobei außerdem zu vermeiden ist, daß der Funktionsraum durch Kühlgeräte belegt wird.

Erfindungsgemäß wird die Aufgabe mit den im Anspruch 1 genannten Merkmalen gelöst. Vorteilhafte Weiterbildungen und Ausgestaltungen sind Gegenstand der Unteransprüche 2 bis 13.

Wesentlich an der Erfindung ist, daß bestimmte Oberflächenbereiche mehrschalig so ausgebildet sind, daß kanalartige Räume, bezogen auf die Funktionsraumwand, innenseitig und außenseitig gebildet werden. Je nach Lastsituation können diese kanalartigen Räume mehr oder weniger intensiv mit Luft beaufschlagt oder weitgehend luftdicht abgeschlossen werden, so daß neben der Kühlung des Funktionsraumes auch eine Wärmedämmung erreichbar ist. Vorteilhaft wird die Funktionsraumwand mit einer Berippung versehen, um deren Oberfläche zu vergrößern und eine Verbesserung des konvektiven Wärmeüberganges zu erreichen.

Die Luftströmung wird im innenseitigen kanalartigen Raum nur durch Lüfter und im außenseitigen kanalartigen Raum durch Lüfter und Auftrieb erzeugt. Die Luftströmung wird durch Kanäle im Bereich der Funktionsraumwand geführt, und im Funktionsraum an die Quellen der Verlustwärme angepaßt.

Die Ausbildung der Berippung erfolgt vorteilhaft in Nadel- oder Streifenform, die dicht und wärmeleitend mit der Funktionsraumwand verbunden werden. Die Berippung kann je nach Einsatzfall freitragend in die kanalartigen Räume ragen oder außen mit der Außenummantelung bzw. innen mit Leitblechen konstruktiv verbunden werden. Dadurch kann der Wärmedurchgangskoeffizient weiter erhöht werden.

Weitere vorteilhafte Ausgestaltungen werden in den Unteransprüchen genannt.

Der Vorteil der erfindungsgemäßen Lösung besteht darin, daß unter Zufügung von wartungsarmen Bauteilen zu den ohnehin vorhandenen Geräteschrankelementen eine Anordnung entsteht, die einen "steuerbaren" Wärmedurchgang aufweist, womit insbesondere die Kühlung aber auch die Wärmedämmung des Funktionsraumes je nach dem Einsatzfall möglich ist. Für die Funktion ist der Energieaufwand gering und kann ausschließlich oder ergänzend durch photovoltaische Module am oder in der Nähe des Geräteschrankes gedeckt werden. Außerdem wird der Funktionsraum nicht durch Kühlgeräte eingeschränkt und die Betriebsführung wird einfacher und billiger.

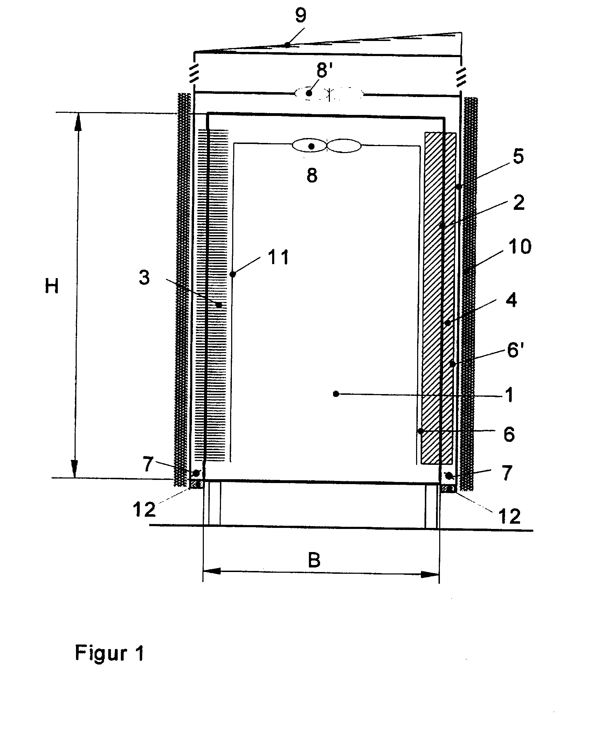

Nachfolgend wird die Erfindung an einem Ausführungsbeispiel näher erläutert. Die einzige Fig. 1 zeigt die Sicht auf eine längs aufgeschnittene Ausführung eines erfindungsgemäßen Geräteschrankes, wobei die wesentlichen Elemente schematisch dargestellt sind, um insbesondere den mehrschaligen Aufbau bestimmter Bereiche der Hüllkonstruktion hervorzuheben.

Im Ausführungsbeispiel ist die abgedichtete Funktionsraumwand 2 eines Funktionsraumes 1 der Breite B, der Höhe H (und der Tiefe T) im Bereich der beiden Seitenwände und der Rückwand mit einer Berippung 3,4 bestückt, wobei mögliche Ausführungen der Berippung in der Figur in Form von Nadel 3 - und Streifenrippen 4 beispielhaft angegeben sind.

Funktionsraumseitig wird der zur Luftbewegung im Funktionsraum 1 verwendete Lüfter 8 so mit Leitblechen 11 verbunden, daß die Luft zunächst die elektrischen Geräte im Funktionsraum 1 umspült und dabei im Kühlbetriebsfall die Verlustleistung von den Geräten abführt und dann entlang der berippten Funktionsraumwand 2 mit relativ hoher Geschwindigkeit strömt und dort thermische Energie an die berippte Funktionsraumwand 2 überträgt. Der im Kühlfall im Wandbereich angestrebte gute Wärmeübergang wird dadurch erreicht, daß die Innenluft den zwischen Leitblechen 11 und Funktionsraumwand 2 gebildeten innenseitigen Strömungskanal 6 vom Lüfter 8 angetrieben, zwangsweise durchströmt und insbesondere bei Verwendung von Nadelrippen 3 an diesen hohe Wärmeübergangskoeffizienten auftreten. Aber auch auf den unberippten Wandteilen zwischen den Nadelrippen treten bedingt durch die lokalen Wirbel ebenfalls erhöhte Wärmeübergangskoeffizienten auf, verglichen mit denen, die bei sonst gleichen Bedingungen an einer glatten Wand erreicht werden.

Anstelle von separaten Leitblechen 11 kann der innenseitige Strömungskanal 6 wenigstens teilweise, durch die Seitenwände der Einschübe gebildet werden.

Da für den Wärmedurchgang durch die Funktionsraumwand 2 gleichermaßen ein guter Wärmeübergang auf der Außenseite nötig ist, um im Kühlfall auch bei geringen Temperaturdifferenzen zwischen Innen- und Außenluft überdurchschnittlich hohe Wärmestromdichten zu erreichen, sind auch außenseitig für den Kühlfall konstruktive Vorkehrungen getroffen, um dies zu realisieren.

Vorteilhaft wird dieses Ziel - wie im Beispiel gezeigt - dadurch erreicht, indem durch einen Außenmantel 5, der die berippten Funktionsraumwandbereiche mit Distanz zu diesen so umschließt, daß ein oben und unten offener außenseitiger kanalartiger Raum 6' (analog zur Innenseite) entsteht, durch den -entweder durch thermischen Auftrieb oder vom im Dachbereich angeordneten Lüfter 8' angetrieben- Außenluft von unten nach oben strömt. Diese Außenluft hat im Kühlfall eine niedrigere Temperatur als die Funktionsraumwand 2 und führt den wesentlichen Teil der Verlustleistung ab.

Die Lüfter 8,8' können kühllastabhängig gesteuert werden.

Da im Außenluftkanal i.a. höhere Luftgeschwindigkeiten realisierbar sind als im Funktionsraum, kann hier die Berippung im Vergleich zur Innenseite u.U. mit geringerer Rippenhöhe ausgeführt werden.

Mindernd auf die Wärmeabfuhr im Außenluftschacht würde der Umstand wirken, wenn durch Sonneneinstrahlung auf den Außenmantel die Außenmantelfläche höhere Temperaturen annehmen würde als die im Außenluftschacht strömende Luft. Um dies zu vermeiden, werden entweder - wie in Fig. 1 dargestellt - auf die Außenseite des Außenmantels 5 schattierend wirkende Zusatzelemente 10 (z. B. künstlicher Efeu) aufgebracht oder der Außenmantel wird doppelwandig ausgeführt, wobei die innere Oberflächen des doppelwandigen Außenmantels niedrige Emissionskoeffizienten für Strahlungsenergie aufweisen und die Luft im doppelwandigen Außenmantel als Wärmedämmschicht wirkt.

Um im außenseitigen Strömungskanal 6' für den Winterbetrieb möglichst ruhende Luftschichten zu erzielen, ist der außenseitige Strömungskanal 6' mittels Klappen 7 verschließbar. Anstelle der Klappen 7 können auch andere Vorkehrungen getroffen werden. Diese werden immer dann betätigt, wenn die Umstellung von Kühl- auf Heizbetrieb und umgekehrt nötig ist.

Außerdem ist für die in den außenseitigen kanalartigen Raum 6' eintretende Außenluft ein Filter 12 vorgesehen.

Die den Kühlbetrieb unterstützenden Lüfter 8,8' werden vorteilhaft mittels photovoltaisch erzeugter Elektroenergie gespeist, weil durch paßfähige Ganglinien der elektrischen Leistungsbereitstellung und der nötigen Lüfterantriebsleistung die Steuerung vereinfacht wird. Durch dachflächengroße Photovoltaik-Module 9, die mit Abstand und damit hinterlüftet über dem Dach des Schrankes montiert werden, wird zugleich die Verschattung des Dachbereiches realisiert.

### Bezugszeichenliste

- 1 -: Funktionsraum
- 2 -: Funktionsraumwand
- 3 -: Nadelrippe
- 4 -: Streifenrippe
- 5 -: Außenmantel
- 6 -: innenseitiger kanalartiger Raum
- 6'-: außenseitiger kanalartiger Raum
- 7 -: Klappe
- 8 -: Lüfter
- 8'-: Lüfter
- 9 -: Photovoltaik-Modul
- 10 -: schattengebendes Zusatzelement
- 11 -: Leitblech
- 12 -: Filter

## Patentansprüche

1. Geräteschrank für elektrische und elektronische Systeme, insbesondere Schalt- und Steuerschrank, mit einem staub- und wasserdicht geschlossenen Funktionsraum (1) und wenigstens einer staub- und wasserdicht schließenden Tür, **dadurch gekennzeichnet, daß** um den Funktionsraum (1) ein mehrschaliger Aufbau vorgesehen ist, der aus Leitblechen (11), Funktionsraumwand (2) und Außenmantel (5) besteht, zwischen Leitbleichen (11) und Funktionsraumwand (2) ein innenseitiger kanalartiger Raum (6) und zwischen Funktionsraumwand (2) und Außenantel (5) ein außenseitiger kanalartiger Raum (6') gebildet wird und die beiden kanalartigen Räume (6,6') mittels steuerbarer Volumenströme unabhängig voneinander lastabhängig beaufschlagbar sind, wobei die Volumenströme in einem Bereich von 0 bis zu einem Maximalwert eingestellt werden können, und der Maximalwert durch die hydraulischen Widerstände der Elemente (12,7,6') und die Kennlinie eines Lüfters (8') einerseits und die hydraulischen Widerstände der Funktionsraumbestükkung, des innenseitigen kanalartigen Raumes (6) und die Kennlinie des Lüfters (8) andererseits bestimmt wird, und somit der Wärmetransport aus dem Funktionsraum (1) zum Außenklima intensiviert bzw. vom Außenklima in den Funktionsraum (1) intensiviert und/oder eingeschränkt werden kann.

2. Geräteschrank nach Anspruch 1, **dadurch gekennzeichnet, daß** die Leitblechen (11) wenigstens teilweise aus den Seitenwänden der in den Funktionsraum angeordneten Einschübe gebildet werden.

3. Geräteschrank nach Anspruch 1 oder 2, **dadurch gekennzeichnet, daß** die kanalartigen Räume (6',6) durch thermischen Auftrieb oder/und durch Fremdantrieb durchströmt werden, oder ruhende Luftschichten eine Isolation erzielen.

4. Geräteschrank nach Anspruch 1 bis 3, **dadurch gekennzeichnet, daß** die Funktionsraumwand (2) wenigstens teilweise eine beidseitige Berippung (3,4) aufweist, wobei die Berippung in die kanalartigen Räume (6',6) ragt.

5. Geräteschrank nach Anspruch 4, **dadurch gekennzeichnet, daß** die Berippung (3,4) in Form von Nadel- und/oder Streifenrippen ausgeführt ist, wobei die Rippen (3,4) dicht und wärmeleitend mit der Funktionsraumwand (2) verbunden sind.

6. Geräteschrank nach Anspruch 5, **dadurch gekennzeichnet, daß** die Höhe der Rippen (3,4) nach außen und innen unterschiedlich ausgebildet ist.

7. Geräteschrank nach einem der Ansprüche 1 bis 6, **dadurch gekennzeichnet, daß** auf der Oberseite des Außenmantels (5) mit Abstand zum Außenmantel (5) und/oder in räumlicher Nähe zum Geräteschrank Photovoltaik-Module (9) vorgesehen sind, die die Antriebsenergie für die fremdangetriebene Konvektion in voller Höhe oder zu einem Teil bereitstellen.

8. Geräteschrank nach einem der Ansprüche 1 bis 7, **dadurch gekennzeichnet, daß** der Außenmantel (5) doppelwandig ausgeführt ist, wobei die Innenseiten des doppelwandig ausgeführten Außenmantels (5) einen niedrigen Emissionskoeffizienten für Strahlungsenergie aufweisen.

9. Geräteschrank nach einem der Ansprüche 1 bis 8, **dadurch gekennzeichnet, daß** der Außenmantel (5) mit schattengebenden Zusatzelementen (10) versehen ist.

10. Geräteschrank nach Anspruch 9, **dadurch gekennzeichnet, daß** die Zusatzelemente (10) natürliche und/oder künstliche Pflanzen sind.

11. Geräteschrank nach Anspruch 1, **dadurch gekennzeichnet, daß** die Luft aus dem innenseitigen kanalartigen Raum (6) beim Eintritt in den Funktionsraum (1) so verteilt wird, daß bevorzugt die Hauptverlustquellen mit kühlluft beaufschlagt werden.

12. Geräteschrank nach Anspruch 11, **dadurch gekennzeichnet, daß** der Lufteintritt in den Funktionsraum (1) durch ein Lochblech erfolgt.

13. Geräteschrank nach Anspruch 1, **dadurch gekennzeichnet, daß** der außenseitige kanalartige Raum (6') mit gefilterten Außenluft beaufschlagt wird.

## Claims

1. Equipment cabinet for electrical and electronic systems, particularly a switch and control cabinet, with a functional area (1) closed in dustproof and watertight manner and at least one door closing in dustproof and watertight manner,
**characterized** in that,
a multishell structure is provided round the functional area (1) and comprises baffle plates (11), functional area wall (2) and outer jacket (5), between baffle plates (11) and functional area wall (2) is formed an internal, channel-like space (6) and between the functional area wall (2) and outer jacket (5) an external, channel-like space (6') and the two channel-like spaces (6,6') can be supplied by controllable volume flows independently of one another in load-dependent manner, the volume flows being adjustable in a range from 0 to a maximum value and the maximum value is determined by the hydraulic resistances of the elements (12, 7, 6') and the characteristics of a fan (8') on the one hand and the hydraulic resistances of the functional area equipment, the internal, channel-like space (6) and the characteristics of the fan (8) on the other hand and consequently the heat transfer from the functional area (1) to the exterior can be intensified or from the exterior into the functional area (1) can be intensified and/or reduced.

2. Equipment cabinet according to claim 1,
**characterized** in that,
the baffle plates (11) are at least partly formed by the side walls of the slide-in modules placed in the functional area.

3. Equipment cabinet according to claim 1 or 2,
**characterized** in that,
the channel-like spaces (6', 6) are flown through by thermal buoyancy and/or separate drive, or static air layers bring about an insulation.

4. Equipment cabinet according to claims 1 to 3,
**characterized** in that,
the functional area wall (2) at least partly has a two-sided rib system (3, 4), which projects into the channel-like spaces (6', 6).

5. Equipment cabinet according to claim 4,
**characterized** in that,
the rib system (3, 4) is constructed in the form of needle and/or strip ribs, the ribs (3, 4) being connected tightly and in heat-conducting manner to the functional area wall (2).

6. Equipment cabinet according to claim 5,
**characterized** in that,
the height of the ribs (3, 4) differs to the outside and inside.

7. Equipment cabinet according to one of the claims 1 to 6,
**characterized** in that,
on the top of the outer jacket (5) and spaced therefrom and/or in the vicinity of the equipment cabinet are provided photovoltaic modules (9), which provide the drive energy for the externally driven convection in either a partial or complete manner.

8. Equipment cabinet according to one of the claims 1 to 7,
**characterized** in that,
the outer jacket (5) has a double wall construction, the insides of the double wall outer jacket (5) having a low emission coefficient for the radiant energy.

9. Equipment cabinet according to one of the claims 1 to 8,
**characterized** in that,
the outer jacket (5) is provided with shade-giving additional elements (10).

10. Equipment cabinet according to claim 9,
**characterized** in that,
the additional elements (10) are natural and/or artificial plants.

11. Equipment cabinet according to claim 1,
**characterized** in that,
when the air from the internal, channel-like space (6) enters the functional area (1) it is distributed in such a way that preferably cooling air is supplied to the main loss sources.

12. Equipment cabinet according to claim 11,
**characterized** in that,
air entry into the functional area (1) takes place through a perforated plate.

13. Equipment cabinet according to claim 1,
**characterized** in that,
the external, channel-like space (6') is supplied with filtered external air.

## Revendications

1. Armoire pour systèmes électriques et électroniques, en particulier une armoire de branchement et de commande, avec un espace fonctionnel (1) fermé de manière étanche à l'eau et à la poussière et au moins une porte se fermant de manière étanche à l'eau et à la poussière,
**caractérisée en ce que**
autour de l'espace fonctionnel (1), is est prévu une structure à plusieurs coques, qui se compose de tôles conductrices (11), d'une paroi (2) d'espace fonctionnel et d'une enveloppe extérieure (5), un espace de type canal intérieur (6) est formé entre les tôles conductrices (11) et la paroi (2) d'espace fonctionnel, et un espace de type canal extérieur (6') est formé entre la paroi (2) d'espace fonctionnel et l'enveloppe extérieure (5), et les deux espaces de type canaux (6, 6') peuvent être chargés indépendamment l'un de l'autre en fonction de la charge au moyen de débits volumiques variables, les débits volumiques pouvant être ajustés dans une plage allant de O à une valeur maximale, et la valeur maximale étant déterminée d'une part par les résistances hydrauliques des éléments (12, 7, 6') et par la caractéristique d'un ventilateur (8') et d'autre part par les résistances hydrauliques des équipements occupant l'espace fonctionnel, de l'espace de type canal intérieur (6) et la caractéristique du ventilateur (8), et ainsi le transport de chaleur de l'espace fonctionnel (1) vers l'atmosphère extérieure peut être intensifié ou bien le transport de chaleur de l'atmosphère extérieure vers l'espace fonctionnel (1) peut être intensifié et/ou limité.

2. Armoire selon la Revendication 1,
**caracterisée en ce que**
les tôles conductrices (11) sont formées au moins en partie par les parois latérales des dispositifs insérables placés dans l'espace fonctionnel.

3. Armoire selon la Revendication 1 ou 2,
**caracterisée en ce que**
les espaces de type canaux (6', 6) sont traversés par le courant thermique ascensionnel et/ou par un entraînement extérieur, ou bien des couches d'air au repos établissent une isolation.

4. Armoire selon la Revendication 1 à 3,
**caracterisée en ce que**
la paroi (2) de l'espace fonctionnel présente au moins partiellement un nervurage (3, 4) des deux faces, le nervurage formant saillie dans les espaces de type canaux (6', 6).

5. Armoire selon la Revendication 4,
**caracterisée en ce que**
le nervurage (3, 4) est réalisé sous la forme de nervures en aiguille et/ou en bandes, les nervures (3, 4) étant reliées de manière étroite et conductrice thermique à la paroi (2) de l'espace fonctionnel.

6. Armoire selon la Revendication 5,
**caracterisée en ce que**
la hauteur des nervures (3, 4) est réalisée différemment en direction de l'extérieur et de l'intérieur.

7. Armoire selon l'une quelconque des Revendications 1 à 6,
**caracterisée en ce que**
sur la face supérieure de l'enveloppe extérieure (5), à distance de l'enveloppe extérieure (5) et/ou à proximité spatiale de l'armoire, sont prévus des modules photovoltaïques (9), qui fournissent en totalité ou en partie l'énergie d'entraînement pour la convection à entraînement externe.

8. Armoire selon l'une quelconque des Revendications 1 à 7,
**caracterisée en ce que**
l'enveloppe extérieure (5) est conformée à double paroi, les faces intérieures de l'enveloppe extérieure (5) à double paroi présentant un plus faible coefficient d'émission radiante.

9. Armoire selon l'une quelconque des Revendications 1 à 8,
**caracterisée en ce que**
l'enveloppe extérieure (5) est munie d'éléments supplémentaires (10) donnant de l'ombre.

10. Armoire selon la Revendication 9,
**caracterisée en ce que**
les éléments supplémentaires (10) sont des plantes naturelles et/ou artificielles.

11. Armoire selon la Revendication 1,
**caracterisée en ce que**
l'air provenant de l'espace de type canal intérieur (6), lors de son entrée dans l'espace fonctionnel (1), est réparti de telle manière que, de préférence, les principales sources de pertes soient exposées à de l'air de refroidissement.

12. Armoire selon la Revendication 11,
**caracterisée en ce que**
l'entrée de l'air dans l'espace fonctionnel (1) se fait à travers une tôle perforée.

13. Armoire selon la Revendication 1,
**caracterisée en ce que**
l'espace de type canal exterieur (6') est exposé à de l'air extérieur filtré.
